# Europäisches Patentamt
# European Patent Office
# Office européen des brevets

(11) Publication number: **0 193 842**
**B1**

# EUROPEAN PATENT SPECIFICATION

(45) Date of publication of patent specification: **18.07.90**

(51) Int. Cl.[5]: **H 01 L 27/08**

(21) Application number: **86102409.9**

(22) Date of filing: **25.02.86**

(54) Integrated semiconductor circuit with two epitaxial layers of different conductivity types.

(30) Priority: **04.03.85 US 708132**

(43) Date of publication of application:
**10.09.86 Bulletin 86/37**

(45) Publication of the grant of the patent:
**18.07.90 Bulletin 90/29**

(84) Designated Contracting States:
**DE FR GB**

(56) References cited:
**US-A-3 639 813**

**INTERNATIONAL ELECTRON DEVICES
MEETING 1979, Washington, D.C., 3rd-5th
December 1979, pages 576-580, IEEE, New York,
US; E.Z. HAMDY et al.: "A novel singel-device-
well mosfet gate"**

**IEEE ELECTRON DEVICE LETTERS, vol. 5, no. 11,
November 1984, pages 454-455, IEEE, New York,
US; M. SHUR: "Folded gate-A novel logic gate
structure"**

(73) Proprietor: **International Business Machines
Corporation
Old Orchard Road
Armonk, N.Y. 10504 (US)**

(72) Inventor: **Brodsky, Marc Herbert
42 Manchester Drive
Mount Kisco New York 10549 (US)**
Inventor: **Fang, Frank Fu
1691 Cardinal Court
Yorktown Heights New York 10598 (US)**

(74) Representative: **Hobbs, Francis John
IBM United Kingdom Limited Intellectual
Property Department Hursley Park
Winchester Hampshire SO21 2JN (GB)**

Courier Press, Leamington Spa, England.

## Description

This invention relates to integrated semiconductor circuits.

As the density of devices on a single semiconductor substrate increases, it is becoming advantageous in the form of speed and occupied area reduction to be able to merge and interconnect different circuit branches and functions into an integrated semiconductor unit.

Circuits of multiple interconnected devices in an integrated substrate have been made on a single plane with the attendant advantages of requiring fewer interconnections, requiring shorter distances between devices and requiring fewer connections on and off the semiconductor substrate. US-A-3,619,740; US-A-3,639,813 and US-A-4,072,868 disclose the integration of active devices with different performance characteristics, interconnected and positioned side by side in a planar surface of a semiconductor substrate.

The invention seeks to provide an improved integrated semiconductor circuit.

An integrated semiconductor circuit comprises, according to the invention, an inner layer of semiconductor material of one conductivity type contiguous with a substrate layer of semiconductor material of the opposite conductivity type and an outer layer of semiconductor material of the opposite conductivity type contiguous with the inner layer a first ohmic contact to a first region of the outer layer, a second ohmic contact to both a first region of the inner layer, a third common ohmic contact to a second region of the outer layer and a second region of the inner layer, the second regions being displaced from the first regions, and control means to vary conduction between the first and second region of the outer layer whereby conduction between the first and second regions of the inner layer is varied.

How the invention can be carried out will now be described by way of example, with reference to the accompanying drawings, in which:

FIG. 1 is a schematic diagram of part of an integrated semiconductor circuit;

FIG. 2 is a schematic diagram of an integrated inverter circuit embodying the invention;

FIG. 3 is a logic circuit diagram of the circuit structure of FIG. 2;

FIG. 4 is a graph of the Current-Voltage performance of the devices in the circuit of FIGS. 2 and 3;

FIG. 5 is a schematic circuit diagram of a cross-coupled bistable logic circuit;

FIG. 6 is a diagrammatic plan of an integrated circuit corresponding to FIG. 5 and embodying the invention; and

FIG. 7 is a diagrammatic cross-section of an integrated circuit corresponding to FIG. 5 and embodying the invention.

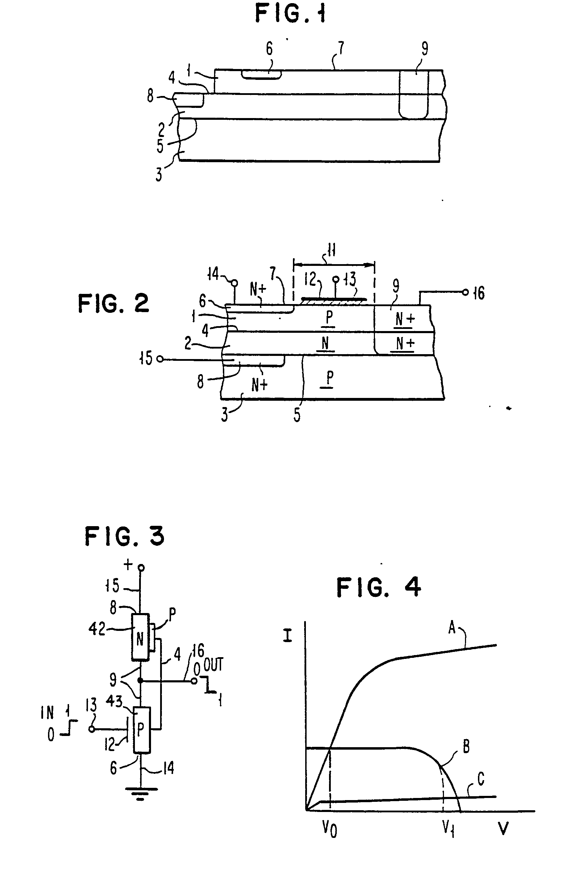

Referring to FIG. 1, an outer layer 1 and a inner layer 2 are formed epitaxially on a substrate layer 3. Adjacent ones of the layers 1, 2 and 3 are of different conductivity types so that p-n junctions are formed at interfaces 4 and 5. In order to facilitate explanation, a configuration with particular interface characteristics and conductivity types will be described although in the light of the principles set forth one skilled in the art will be able to apply the invention to many configurations.

There are two superimposed current paths parallel to the surface in layers 1 and 2. Individual separate ohmic contacts are provided to each layer, contact 6 in the surface 7 for layer 1 and contact 8 for layer 2.

A common ohmic contact 9 joins the current paths in layers 1 and 2 and provides an output node in the circuit path. Depending on the circuit being integrated, the contact 9 may not necessarily have to come to the surface of a packaged integrated circuit.

The current path in layer 1 where the surface 7 is exposed is thus adaptable to current control modifications applied external to the semiconductor crystal. Such modifications would be, for example, field effect transistor gates or optical carrier generation. Each can influence both carrier movement and carrier concentration in the exposed region of layer 1. The exposed region in layer 1 in a preferred example corresponds to a field effect transistor channel between contacts 6 and 9. Thus, the current in layer 1 is an inversion layer current at the surface 7 adjacent to the insulating gate to be deposited on the surface 7.

The current path in layer 2 is such that the current therein is influenced by internal crystal conditions, such as the bulk conductivity. In addition to resistivity built in in the form of doping, the current in layer 2 can also have the conductivity therein alterable by a depletion region produced by a potential at the interfaces 4 and 5 which are p-n interfaces or heterojunctions. The conduction exhibits non-linear characteristics between the contacts. Layer 1 can serve as a p-n junction gate of a depletion mode field effect transistor in layer 2.

The invention is particularly applicable to the integration cf circuitry where a current control device is positioned in series with another device or a load between two points of separate potential in a circuit and an output is located in the series path between the two devices. In such circuit branches, the output signal is developed between the devices, for example, between a control device and a load. In integrating such a circuit branch vertically as shown in FIG. 1 the current path containing the current control device would be fabricated in layer 1 between the contacts 6 and 9 and another current control device or the load current path would be in layer 2 between contacts 8 and 9.

A typical circuit illustrating the connecting of the elements of a circuit branch in series between two points at different potential where the signal is taken at a node in the branch is the inverter logic circuit. In this type of circuit, a control device and a load device are connected in series between two points in a circuit. The control device in this case is a "normally off" device such as an enhancement mode field effect transistor (FET) and the load device is a "normally on" device such as a depletion mode junction FET, with the layer 1 serving as an integrated gate. When a signal of one polarity, such as the power supply voltage, is applied to the control device, the current through both the control device and the load device in series is enhanced. This will cause a non-linear decrease of an output voltage at a node between the devices.

The integration and performance of such a circuit is shown in FIGS. 2, 3 and 4.

For purposes of explanation and continuity with subsequent illustrations specific conductivity types and control device types will be selected for illustration. However, in the light of the principles set forth it will be apparent to one skilled in the art that considerable variation in doping, types of semiconductor materials and current control mechanisms may be made.

In a merged n-channel FET inverter circuit (FIG. 2), the three layers 1, 2 and 3 may be a part of a more extensive substrate that is not shown. All three are epitaxial at the interfaces forming thereby a single crystal with p-n junctions 4 and 5 between the adjacent regions. A first low resistivity ohmic contact 6 shown as $n^+$ makes contact to the inversion layer under a gate electrode 12. A second low resistivity ohmic region 8 shown as $n^+$ is formed at the interface of layers 2 and 3 in the general vicinity of and under the contact 6. A third low resistivity region 9 is positioned in the surface 7 a distance 11 from the contact 6 sufficient to accommodate the gate electrode 12. The region 9 is shown as $n^+$ in FIG. 2 and extends through layer 1 and forms an ohmic contact with layer 2.

The fabrication of the structure of FIG. 2 would be from the p-type substrate 3 up as follows. In the p-type substrate 3 the $n^+$ contact 8 is formed in the shape of a long stripe by masking and diffusion or ion implantation. Upon mask removal the n layer 2 and the p layer 1 are epitaxially grown to the desired thickness and doping by metal organic chemical vapour deposition or molecular beam epitaxy. Conventional masking and deposition are employed to form the $n^+$ region 6, the gate insulator 13 and the gate electrode 12. A reach-through implant is employed for the $n^+$ contact 9.

In FIG. 2 the control electrode for the path in layer 1 is shown schematically as a field effect transistor gate. The function of the gate 12 is to influence the carriers and thereby to control conduction in the layer 1 between contacts 6 and 9 such as would occur in a semiconductor device FET channel. In FIG. 2 a positive potential on the gate 12 produces an n-type inversion layer at the interface of the p-type layer 1 and the insulator 13.

The type of control function employed is usually governed by the response specifications of the circuit being integrated.

In the path in layer 1, a preferred type of gated control device is the enhancement mode field effect transistor, wherein the p-doping level in region 1 is adjusted so that a moderate + signal applied to the gate 12 inverts the conductivity of the semiconductor near the interface of layer 1 and insulator 13 to n-type. With the enhancement mode type of device, current flow only takes place in the presence of a signal on the gate. In devices called n-channel, where the channel region is n type, the carriers are electrons which have higher mobility with resulting higher speed. The opposite type of dopants with the opposite sign of electric polarity provide p-channel devices which could alternatively be used.

Current flowing in layer 2 between the contact 8 and the contact 9 will be determined by the carrier concentration and thickness of the layer 2 and by any potential along the bounding p-n junctions 4 and 5 in the manner of known junction field effect transistor (JFET) operation. The flow of the current in layer 2 is thus non-linear and nearly constant for a large voltage between terminals 8 and 9.

In the inverter type circuit being described, layer 2 serves as a load for the enhancement mode field effect transistor current control device in layer 1.

Circuit flexibility and packing density advantages arise because the structure provides the ability to externally, through a signal introduced at the surface, control conduction between an independent and a common ohmic contact and to control by the resistance and/or the space charge associated with a p-n junction the conductivity in the central region between an independent and a common ohmic contact with a signal being reachable at the common contact.

Referring next to FIG. 3, a typical circuit branch is illustrated where active and passive elements are connected in series between two points of different potential. The circuit illustrated is the enhancement/depletion FET inverter circuit. The diagram of the inverter circuit of FIG. 3 is provided with reference numerals corresponding to the structural elements in FIG. 2.

Referring to FIGS. 2 and 3 together, in the circuit, the load device 42 is an n-channel JFET transistor located in layer 2 of FIG. 2. The drain electrode of the load device 42 is the contact 8 which is connected to + through conductor 15. Common contact 9 serves as the source electrode of the JFET and is the output to terminal 16 for both the JFET and the MOSFET. The MOSFET 43 uses contact 6 as its source electrode which is connected through conductor 14 to reference or ground. The inverted portion of layer 1 under the gate 12 serves as the channel of the MOSFET.

The output in FIG. 3 is produced on terminal 16 while the input is to gate 12. Conduction in the JFET channel in layer 2 is controlled by the potential on the p-n junction at the interface 4 common to layers 1 and 2 and the voltage between terminals 8 and 9. This interface 4 serves as the JFET gate electrode as indicated in FIG. 3. A positive signal at gate 12 operates to turn on the MOSFET which in turn causes the potential at the output terminal 16 to move towards ground providing thereby an inverted signal to that impressed at the gate 12.

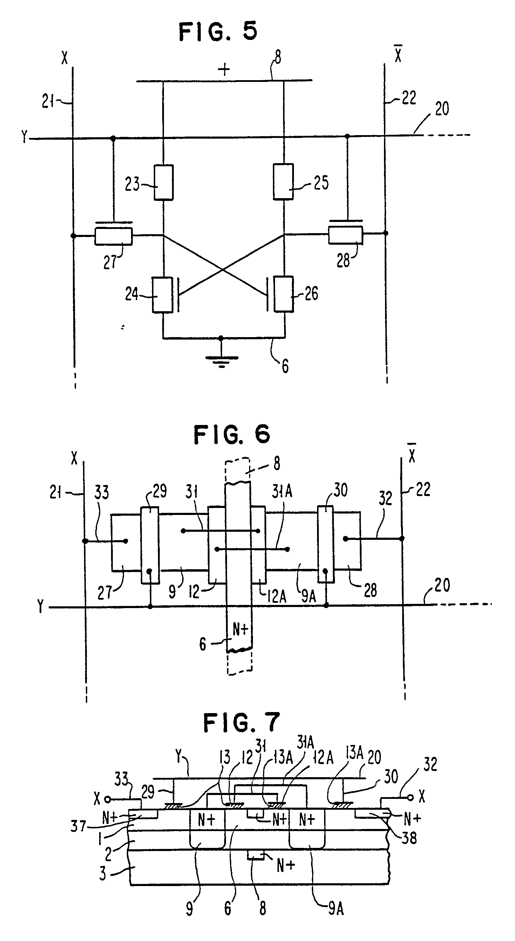

The advantages and flexibility obtained are further illustrated in connection with the combined output characteristic curves of the devices in the superimposed current paths. The performance of each current path device is combined in the current-voltage (I-V) characteristic curve of FIG. 4. In FIG. 4, the curves labelled A and C are the transfer characteristics of the MOSFET, with the gate 12 voltage "on" and "off", respectively. The curve labelled B is the transfer characteristic of the JFET in the current path in layer 2. Performance follows the curve A when a positive signal is applied to gate 12 with a threshold at $V_0$ and performance is at $V_1$ on curve C when the signal on the gate 12 is 0. Thus, clearly defined threshold and saturation limits are established.

The structure itself, while discussed in connection with silicon involving inversion layers, may also be constructed of group III-V intermetallic compound semiconductors and alloys thereof, such as a GaAs/AlGaAs heterojunction structure. Such structures are usually built using the molecular beam epitaxy technique. In such a structure, the gate 12 would be a GaAs region epitaxial with an AlGaAs region epitaxial with the surface 7 of the layer 1 of p-GaAs. The layer 2 would be n-GaAs and the layer 3 would be semi-insulating GaAs. Thus, the control device would be a high electron mobility transistor (HEMT) and the load device would be a JFET.

In a further variation, the gate 12 would be n+-GaAs or metal epitaxial with AlGaAs in turn epitaxial with the surface 7 of a p-GaAs layer 1.

The layer 1 would be epitaxial with an AlGaAs layer 2 on a semi-insulating GaAs substrate layer 3. The resulting structure would provide a HEMT control device and a HEMT load device.

Other features would involve carrier introduction through the surface 7 by light.

Application of the invention is also particularly useful when integrating arrays of devices. In such arrays the overall circuits employ many building subcircuit blocks which form a functional circuit. Memory arrays are an illustration where quantities of building block elements such as individual bit storage units are wired in a pattern such as an orthogonal grid to provide a multi-bit memory of a certain size and accessibility.

Application of the invention to integrating such building block circuits will be described, by way of example, with reference to FIGS. 5, 6 and 7.

A conventional cross-coupled bistable memory cell complete with addressing gates is shown in FIG. 5. The circuit has two inverter circuit branches made up of a control device and a load in series connected between positive and reference or ground (such as shown in FIG. 3) interconnected into a storage unit by having the outputs cross coupled. In FIG. 5, the outputs are connected to the X orthogonal signal lines through control devices that are responsive to a Y orthogonal signal. Such a circuit has symmetry which makes application of this invention particularly suitable.

In FIG. 5, a conductor 20 is the Y orthogonal line of an array. The X orthogonal conductors 21 and 22 carry signals representative of the X and $\overline{X}$ logic functions, respectively. One inverter branch circuit includes devices 23 and 24 in series while the other inverter branch circuit includes devices 25 and 26. The outputs of the inverters are cross coupled to the gates of the control device in the other branch.

Addressing and output FET devices 27 and 28 are provided with gates 29 and 30 to sense a signal on the conductor 20 and to pass the output signals to the conductors 21 and 22 on a change of state.

FIG. 6 is a diagrammatic plan of the circuit of FIG. 5 when formed in a semiconductor crystal by application of the invention. In order to emphasize how the invention is advantageous in integrating symmetrical circuitry, corresponding contacts in the symmetrical portion are labelled with the letter A.

In FIG. 6, the contact 6 of FIGS. 1 and 2 is shown in the centre and serves as the ground or reference potential connection as shown in FIGS. 3 and 5. The contact 8 is directly thereunder and is shown dotted. The common contact 9 is duplicated as 9A for the second branch and is positioned on the other side of the contact 6. The gate 12 is similarly duplicated as 12A and each is positioned on one side and directly adjacent to the contact 6 over the exposed portion of the layer between contacts 6 and 9 and 9A. The cross-coupling 31 and 31A thus becomes very simple and merely joins each gate to the opposite branch common contact, crossing only one gate and the contact 6. The channel portions of the addressing and output FET transistors 27 and 28 are respectively to the left and right extremes in FIG. 6 and the gates for those transistors are labelled 29 and 30, respectively, and are positioned over the exposed parts of the semiconductor crystal between 37 and 38 and 9 and 9A, respectively. The power + line 8, being a buried n$^+$ region, is contacted at the perimeter of the semiconductor chip as is standard in the art.

The integration is seen in different perspective in the cross section view of FIG. 7. It should be noted, as illustrated in FIG. 7, that both the surface current path conductor 6 that is connected to reference or ground and the lower current path conductor 8 that is connected to positive serve both symmetrical branches of the memory circuit. In FIGS. 6 and 7 all field effect transistors 24, 26, 27 and 28 are MOSFET devices that operate by inverting the p conductivity in the dotted region to n and are symmetrically positioned. The load devices 23 and 25 are in the lower current paths in layer 2 between the n$^+$ contact 8 connected to + and the contacts 9 and 9A respectively.

The structure is preferably realised in silicon wherein the layers of the individual layers 1 and 2 are approximately 1 micron thick and layers 1, 2 and 3 are doped to approximately $10^{16}$ atoms per cc with respectively arsenic for n-doping and boron for p-doping. The contact 8 may be provided prior to the various layers being epitaxially grown by providing a layer of phosphorous or arsenic on the substrate layer 3 which is usual for long lines. As shown in FIG. 1 electrical connection can be made by removing a portion of the layer 1 at the desired region, usually the periphery of the chip. The contact 6 is provided by diffusing phosphorous or arsenic into the surface as are the contacts 32 and 33. The common contacts 9 and 9A are provided by reach-through implantation or diffusion of phosphorous or arsenic prior to the shallow diffusions for 6, 32 and 33. The gates 12, 12A, 29 and 30 are provided by depositing metal or polysilicon on the insulators 13 and 13A. All wiring is provided by masking and aluminium or polysilicon deposition well known in the art.

## Claims

1. An integrated semiconductor circuit comprising an inner layer (2) of semiconductor material of one conductivity type contiguous with a substrate layer (3) of semiconductor material of the opposite conductivity type and an outer layer (1) of semiconductor material of the opposite conductivity type contiguous with the inner layer, a first ohmic contact (6) to a first region of the outer layer, a second ohmic contact (8) to a first region of the inner layer, a third common ohmic contact (9) to both a second region of the outer layer and a second region of the inner layer, the second regions being displaced from the first regions, and control means (12) to vary conduction between the first and second region of the outer layer whereby conduction between the first and second regions of the inner layer is varied.

2. An integrated circuit as claimed in claim 1, in which the first and second regions and the portion therebetween of the outer layer and the control means form a control device, the first and second regions and the portion therebetween of the inner layer form a load device, and the third common ohmic contact forms an output terminal for the circuit comprised by the control device and the load device.

3. An integrated circuit as claimed in claim 2, wherein said control device is an enhancement mode FET and said load-device is a depletion mode FET.

4. An integrated circuit as claimed in claim 2, wherein said control device is a MOSFET and said load device is a JFET.

5. An integrated circuit as claimed in any preceding claim, formed in a silicon crystal.

6. An integrated cicuit as claimed in claim 4, wherein the control device is an enhancement mode MOSFET and the load device is a depletion mode JFET, the control and load devices forming an inverter circuit.

7. An integrated circuit as claimed in any preceding claim, in which the outer layer is of p-type silicon, the inner layer is of n-type silicon and the substrate layer is of p-type silicon.

8. An integrated circuit as claimed in any claims 1 to 5, formed in a group III-V intermetallic compound semiconductor crystal.

9 An integrated circuit as claimed in claim 7, in which the outer layer is of p-type GaAs, the inner layer is of n-type GaAs and the substrate layer is of GaAs.

10. A symmetrical circuit structure including first and second integrated circuits each as claimed in any preceding claim, formed in a common monolithic semiconductor crystal the first and second integrated circuits being mirror symmetrically disposed on opposite sides of superimposed common first ohmic (6) and second ohmic (8) contacts to the outer and inner layers.

## Patentansprüche

1. Integrierter Halbleiterkreis, enthaltend eine innere Schicht (2) aus Halbleitermaterial von einem Leitungstyp, angrenzend an eine Substratschicht (3) aus Halbleitermaterial von dem entgegengesetzten Leitungstyp und eine andere Schicht (1) aus Halbleitermaterial von dem entgegengesetzten Leitungstyp, angrenzend an die innere Schicht, einen ersten ohmischen Kontakt (6) zu einem ersten Bereich der äusseren Schicht, einen zweiten ohmischen Kontakt (8) zu einem ersten Bereich der inneren Schicht, einen dritten gemeinsamen ohmischen Kontakt (9) zu sowohl einem zweiten Bereich der äusseren Schicht als auch zu einem zweiten Bereich der inneren Schicht, wobei die zweiten Bereiche von den ersten Bereichen versetzt sind, und Steuermittel (12), um die Leitung zwischen dem ersten und zweiten Bereich der äusseren Schicht zu verändern, wodurch die Leitung zwischen den ersten und zweiten Bereichen der inneren Schicht verändert wird.

2. Integrierter Schaltkreis nach Anspruch 1, in welchem die ersten und zweiten Bereiche und der dazwischenliegende Teil der äusseren Schicht und die Steuermittel eine Steuervorrichtung bilden, die ersten und zweiten Bereiche und der dazwischenliegende Teil der inneren Schicht eine Lastvorrichtung bilden, und der dritte gemeinsame ohmische Kontakt einen Ausgangsanschluss für den durch die Steuervorrichtung und die Lastvorrichtung eingeschlossenen Schaltkreis bildet.

3. Integrierter Schaltkreis nach Anspruch 2, worin die genannte Steuervorrichtung ein Anreicherungs-Isolierschicht-FET und die genannte Lastvorrichtung ein Sperrschicht-FET ist.

4. Integrierter Schaltkreis nach Anspruch 2, worin die genannte Steuervorrichtung ein MOSFET und die genannte Lastvorrichtung ein JFET ist.

5. Integrierter Schaltkreis nach einem der vorangehenden Ansprüche ausgestaltet als Silikonkristall.

6. Integrierter Schaltkreis nach Anspruch 4, worin die Steuervorrichtung ein Anreicherungs-Isolierschicht-MOSFET und die Lastvorrichtung ein Sperrschicht-JFET ist, wobei die Steuer- und Lastvorrichtung einen Inverterkreis bilden.

7. Integrierter Schaltkreis nach einem der vorangehenden Ansprüche, in welchem die äussere Schicht aus p-dotiertem Silikon, die innere Schicht aus n-dotiertem Silikon und die Substratschicht aus p-dotiertem Silikon besteht.

8. Integrierter Schaltkreis nach einem der Ansprüche 1 bis 5 aus, einem intermetallischen Verbundhalbleiterkristall der Gruppe III-V bestehend.

9. Integrierter Schaltkreis nach Anspruch 7, in welchem die äussere Schicht aus p-dotiertem GaAs, die innere Schicht aus n-dotiertem GaAs und die Substratschicht aus GaAs bestehen.

10. Symmetrische Shaltkreisstruktur, enthaltend erste und zweite integrierte Schaltkreise jeweils nach einem der vorangehenden Ansprüche aus einem gemeinsamen monolithischen Halbleiterkristall bestehend, wobei die ersten und zweiten integrierten Schaltkreise auf entgegengesetzten Seiten von übereinanderliegenden gemeinsamen ersten (6) ohmischen und zweiten (8) ohmischen Kontakten zu den äusseren und inneren Schichten spiegelgleichweise angeordnet sind.

## Revendications

1. Circuit intégré semi-conducteur comprenant une couche intérieure (2) de matière semi-conductrice d'un certain type de conductivité, contiguë à une couche de substrat (3) de matière semi-conductrice du type de conductivité opposé, et une couche extérieure (1) de matière semi-conductrice du type de conductivité opposé contiguë à la couche intérieure, un premier contact ohmique (6) sur une première région de la couche extérieure, un deuxième contact ohmique (8) sur une première région de la couche intérieure, un troisième contact ohmique (9) commun à la fois à une deuxième région de la couche extérieure et à une deuxième région de la couche intérieure, les deuxièmes régions étant espacées des premières régions, et des moyens de commande (12) pour modifier la conduction entre les première et deuxième régions de la couche extérieure, de sorte que la conduction entre les première et deuxième régions de la couche intérieure est modifiée.

2. Circuit intégré suivant la revendication 1, dans lequel les première et deuxième régions et la partie intermédiaire de la couche extérieure et les moyens de commande constituent un dispositif de commande, les première et deuxième régions et la partie intermédiaire de la couche intérieure constituent un dispositif de charge, et le troisième contact ohmique commun constitue une borne de sortie pour le circuit composé par le dispositif de commande et le dispositif de charge.

3. Circuit intégré suivant la revendication 2, dans lequel ledit dispositif de commande est un FET en mode d'enrichissement et ledit dispositif de charge est un FET en mode d'appauvrissement.

4. Circuit intégré suivant la revendication 2, dans lequel ledit dispositif de commande est un MOSFET et ledit dispositif de charge est un JFET.

5. Circuit intégré Suivant l'une quelconque des revendications précédentes, formé dans un cristal de silicium.

6. Circuit intégré suivant la revendication 4, dans lequel le dispositif de commande est un MOSFET en mode d'enrichissement et le dispositif de charge est un JFET en mode d'appauvrissement, les dispositifs de commande et de charge formant un circuit inverseur.

7. Circuit intégré suivant l'une quelconque des revendications précédentes, dans lequel la couche extérieure est en silicium de type p, la couche intérieure est en silicium de type n et la couche de substrat est en silicium de type p.

8. Circuit intégré suivant l'une quelconque des revendications 1 à 5, formé dans un cristal semi-conducteur de composé intermétallique des groupes III-V.

9. Circuit intégré suivant la revendication 7, dans lequel la couche extérieure est en GaAs de type p, la couche intérieure est en GaAs de type n et la couche de substrat est en GaAs.

10. Structure de circuit symétrique comprenant un premier et un deuxième circuits intégrés, chacun suivant l'une quelconque des revendications précédentes, formée dans un cristal semi-conducteur monolithique commun, les premier et deuxième circuits intégrés étant disposés symétriquement sur les côtés opposés des premier (6) et second (8) contacts ohmiques communs superposés avec les couches extérieure et intérieure.

FIG. 1

FIG. 2

FIG. 3

FIG. 4

# FIG. 5

# FIG. 6

# FIG. 7

2